(19) Europäisches Patentamt
European Patent Office
Office européen des brevets

(11) **EP 3 292 416 B1**

(12) **EUROPÄISCHE PATENTSCHRIFT**

(45) Veröffentlichungstag und Bekanntmachung des Hinweises auf die Patenterteilung:
**24.11.2021 Patentblatt 2021/47**

(21) Anmeldenummer: **16708661.0**

(22) Anmeldetag: **08.03.2016**

(51) Int Cl.:
***G01R 15/24*** *(2006.01)*

(86) Internationale Anmeldenummer:
**PCT/EP2016/054872**

(87) Internationale Veröffentlichungsnummer:
**WO 2016/177490 (10.11.2016 Gazette 2016/45)**

(54) **VERFAHREN ZUM MESSEN EINES ELEKTRISCHEN STROMS UND STROMSENSOR**

METHOD FOR MEASURING AN ELECTRICAL CURRENT AND CURRENT SENSOR

PROCÉDÉ DE MESURE D'UN COURANT ÉLECTRIQUE ET CAPTEUR DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.05.2015 DE 102015208151**

(43) Veröffentlichungstag der Anmeldung:
**14.03.2018 Patentblatt 2018/11**

(73) Patentinhaber: **Robert Bosch GmbH**
**70442 Stuttgart (DE)**

(72) Erfinder:
• **LUTZ, Theresa**
**81545 München (DE)**
• **SCHATZ, Frank**
**70806 Kornwestheim (DE)**
• **ROELVER, Robert**
**75365 Calw-Stammheim (DE)**

(56) Entgegenhaltungen:
**WO-A1-2013/188732   WO-A1-2015/107907**
**US-A1- 2011 120 890   US-A1- 2015 090 033**

## Beschreibung

Stand der Technik

Die vorliegende Erfindung bezieht sich auf ein Verfahren zum Messen eines elektrischen Stroms, auf einen entsprechenden Stromsensor sowie auf ein entsprechendes Computerprogramm.

Zur Messung von elektrischen Strömen stehen heute bereits Lösungen wie die Messung des Spannungsabfalls an einem Shunt Widerstand oder die Messung strominduzierter Magnetfelder über Hall- sowie Magnetfeld-Sensoren auf der Basis des Tunnelling Magneto Resistance bzw. des Giant Magnetoresistance Effekts zur Verfügung (TMR und GMR Sensoren).

WO 2013/188732 A1 offenbart ein Verfahren und eine Vorrichtung zur Detektion elektrischer Ströme mittels einer Sensorvorrichtung, welche auf NV-Zentren in Diamant basiert.

US 2011/0120890 A1 beschreibt ein Verfahren zur Einzel-Molekül-Detektion eines Analyten und den zugehörigen Sensor.

Offenbarung der Erfindung

Vor diesem Hintergrund werden mit dem hier vorgestellten Ansatz ein Verfahren zum Messen eines elektrischen Stroms unter Verwendung eines Diamantmaterials, weiterhin ein Stromsensor mit einem Diamantmaterial sowie schließlich ein entsprechendes Computerprogramm gemäß den Hauptansprüchen vorgestellt. Vorteilhafte Ausgestaltungen ergeben sich aus den jeweiligen Unteransprüchen und der nachfolgenden Beschreibung.

Ein elektrischer Stromfluss in einem elektrischen Leiter verursacht ein Magnetfeld um den Leiter. Ein Stickstoff-Fehlstellen-Zentrum in einem Diamantkristall weist aufgrund des Zeemann Effekts eine hohe Empfindlichkeit für das Magnetfeld auf. Das Stickstoff-Fehlstellen-Zentrum kann optisch mit einem großen Wertebereich ausgelesen werden, wodurch der Stromfluss mit einer hohen Genauigkeit bestimmt werden kann.

Es wird ein Verfahren zum Messen eines ein Magnetfeld bewirkenden elektrischen Stroms gemäß Anspruch 1 unter Verwendung eines dem Magnetfeld aussetzbaren Diamantmaterials vorgestellt, wobei das Diamantmaterial zumindest eine Stickstoffeinlagerung und eine zu der Stickstoffeinlagerung benachbarte Fehlstelle in einem Kristallgitter des Diamantmaterials aufweist, wobei das Verfahren die folgenden Schritte aufweist:

Bereitstellen von ersten elektromagnetischen Wellen in einem ersten Frequenzspektrum und von zweiten elektromagnetischen Wellen in einem zweiten Frequenzspektrum, um das Diamantmaterial zu einer Fluoreszenz anzuregen;

Erfassen einer Fluoreszenz-Intensität der Fluoreszenz;

Auswerten der Intensität und einer Frequenz der zweiten elektromagnetischen Wellen, um eine die Fluoreszenz beeinflussende magnetische Feldstärke des Magnetfelds zu ermitteln; und

Bestimmen einer Stromstärke des Stroms unter Verwendung der magnetischen Feldstärke.

Unter einem Diamantmaterial kann Diamant mit zumindest einem Stickstoff-Fehlstellen-Zentrum verstanden werden. Ein Stickstoff-Fehlstellen-Zentrum kann eine Stickstoffeinlagerung in ein Kristallgitter des Diamanten und eine zu der Stickstoffeinlagerung benachbarte Fehlstelle in dem Kristallgitter sein. Das Stickstoff-Fehlstellen-Zentrum weist eine Empfindlichkeit für ein magnetisches Feld wie es beispielsweise von einem stromdurchflossenen Leiter ausgeht auf. Zumindest eine zu einem lokalen Minimum einer Fluoreszenz beziehungsweise eines Fluoreszenzspektrums des Diamantmaterials zugeordnete Anregungsfrequenz verschiebt sich proportional zu einer magnetischen Feldstärke des Magnetfelds. Die magnetische Feldstärke kann einfach in die verursachende Stromstärke umgerechnet werden, beispielsweise unter Verwendung einer vorbestimmten Verarbeitungsvorschrift. Eine einfache Auswertung kann beispielsweise über eine Schwellenwertüberwachung der Fluoreszenzintensität erfolgen. Dabei können die ersten elektromagnetischen Wellen mit einer konstanten und die zweiten elektromagnetischen Wellen mit variabler Frequenz bereitgestellt werden. Durch Unterschreiten des Schwellwerts erhält man direkt die Lage der Intensitätsminima, die charakteristisch für ein Magnetfeld bestimmter Feldstärke sind.

Im Schritt des Auswertens kann ein erstes lokales Intensitätsminimum der Fluoreszenz bei einer ersten Frequenz der zweiten elektromagnetischen Wellen ausgewertet werden. Weiterhin kann ein zweites lokales Intensitätsminimum der Fluoreszenz bei einer zweiten Frequenz der zweiten elektromagnetischen Wellen ausgewertet werden. Die Feldstärke kann unter Verwendung eines Frequenzabstands zwischen den Frequenzen ermittelt werden. Die erste Frequenz und die zweite Frequenz verändern sich bei gleichbleibenden Umweltbedingungen näherungsweise linear zu einer Veränderung des Magnetfelds.

Im Schritt des Bereitstellens können die zweiten elektromagnetischen Wellen als Frequenzverlauf eingestrahlt werden. Im Schritt des Erfassens kann ein Intensitätsverlauf der Fluoreszenz erfasst werden. Im Schritt des Auswertens kann die Feldstärke unter Verwendung eines Zusammenhangs zwischen dem Frequenzverlauf und dem Intensitätsverlauf ermittelt werden. Das Diamantmaterial kann mit einer veränderlichen Anregungsfrequenz durch die zweiten elektromagnetischen Wellen angeregt werden. Insbesondere kann ein vorbestimmter Frequenzbereich vollständig überstrichen werden. Dadurch kann das zumindest eine Fluoreszenzminimum einfach erfasst werden.

Das Diamantmaterial kann als erste elektromagnetische Wellen mit Licht und als zweite elektromagnetische Wellen mit Mikrowellenenergie angeregt werden. Insbesondere kann das Diamantmaterial gleichzeitig mit Licht und Mikrowellenenergie angeregt werden. Dabei kann das Licht mit einer gleichbleibenden Wellenlänge bereitgestellt werden, während die Mikrowellenenergie mit veränderbaren Frequenzen bereitgestellt werden kann. Dadurch kann das Magnetfeld besonders gut gemessen werden.

Im Schritt des Bereitstellens kann ferner ein Referenzmagnetfeld mit einer Referenzfeldstärke und einer Referenzfeldrichtung bereitgestellt werden. Im Schritt des Auswertens kann durch Abgleich zwischen Fluoreszenzspektrum im Magnetfeldfreien Fall und dem unter dem zu messenden Magnetfeld aufgenommenen Fluoreszenzspektrum die Magnetfeldstärke und Richtung des zu messenden Feldes ermittelt werden. Durch diesen Abgleich können zum Beispiel Störfelder aus anderen Richtungen von dem zu messenden Magnetfeld eines stromdurchflossenen Leiters unterschieden werden.

Das Verfahren kann einen Schritt des optischen Filterns der Emission des Diamantmaterials aufweisen, um die Fluoreszenz des Diamantmaterials aus dem Streulicht z. B. aus der optischen Anregung der Fluoreszenz herauszufiltern, wodurch eine Messgenauigkeit vergrößert werden kann.

Im Schritt des Auswertens kann ferner eine Temperatur des Diamantmaterials durch Auswertung der beispielsweise durch Schwellenwertdetektion aufgenommenen Frequenzen ermittelt werden. Die Frequenz beziehungsweise die Frequenzen, über die das Magnetfeld ermittelt wird, verschieben sich temperaturabhängig. Dadurch kann direkt aus den temperaturabhängigen Frequenzverschiebungen der lokalen Minima die Temperatur abgeleitet werden.

Weiterhin wird ein Stromsensor zum Messen eines ein Magnetfeld bewirkenden elektrischen Stroms gemäß Anspruch 7 vorgestellt, wobei der Stromsensor die folgenden Merkmale aufweist:

ein dem Magnetfeld aussetzbares Diamantmaterial, das zumindest eine Stickstoffeinlagerung und eine zu der Stickstoffeinlagerung benachbarte Fehlstelle im Kristallgitter des Diamantmaterials aufweist;

einen Emitter zum Bereitstellen von ersten elektromagnetischen Wellen in einem ersten Frequenzspektrum und von zweiten elektromagnetischen Wellen in einem zweiten Frequenzspektrum, um das Diamantmaterial zu einer Fluoreszenz anzuregen;

einen Sensor zum Erfassen einer Fluoreszenz-Intensität einer Fluoreszenz;

eine Auswerteeinrichtung zum Ermitteln einer Feldstärke des Magnetfelds unter Verwendung der Fluoreszenz-Intensität und einer Frequenz der zweiten elektromagnetischen Wellen; und

eine Bestimmungseinrichtung zum Bestimmen einer Stromstärke des Stroms unter Verwendung der magnetischen Feldstärke.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Der hier vorgestellte Ansatz wird nachstehend anhand der beigefügten Zeichnungen beispielhaft näher erläutert. Es zeigen:

Fig. 1 ein Blockschaltbild eines Stromsensors gemäß einem Ausführungsbeispiel der vorliegenden Erfindung;

Fig. 2 ein Ablaufdiagramm eines Verfahrens zum Messen eines Stroms gemäß einem Ausführungsbeispiel der vorliegenden Erfindung;

Fig. 3 eine Darstellung eines Diamantmaterials mit einer Stickstoffeinlagerung und einer Fehlstelle gemäß einem Ausführungsbeispiel der vorliegenden Erfindung;

Figuren 4a, 4b, 4c eine Funktionsweise und Energieschemata der Strommessung über Fluoreszenzmessung bei zusätzlicher Mikrowellenanregung gemäß einem Ausführungsbeispiel der vorliegenden Erfindung;

Fig. 5 eine Darstellung der möglichen Lagen einer Fehlstelle in der Kristallstruktur eines Diamantmaterials gemäß einem Ausführungsbeispiel der vorliegenden Erfindung;

Fig. 6 lokale Intensitätsminima in Abhängigkeit von der Lage einer Fehlstelle in der Kristallstruktur eines Diamantmaterials gemäß einem Ausführungsbeispiel der vorliegenden Erfindung;

Fig. 7 eine Darstellung eines Stromsensors gemäß einem Ausführungsbeispiel der vorliegenden Erfindung;

die Figuren 8a, 8b Einbaubeispiele von Stromsensoren gemäß Ausführungsbeispielen der vorliegenden Erfindung; und

die Figuren 9a, 9b eine Funktionsweise und Energieschemata der Temperaturmessung über Fluoreszenzmessung bei zusätzlicher Mikrowellenanregung gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

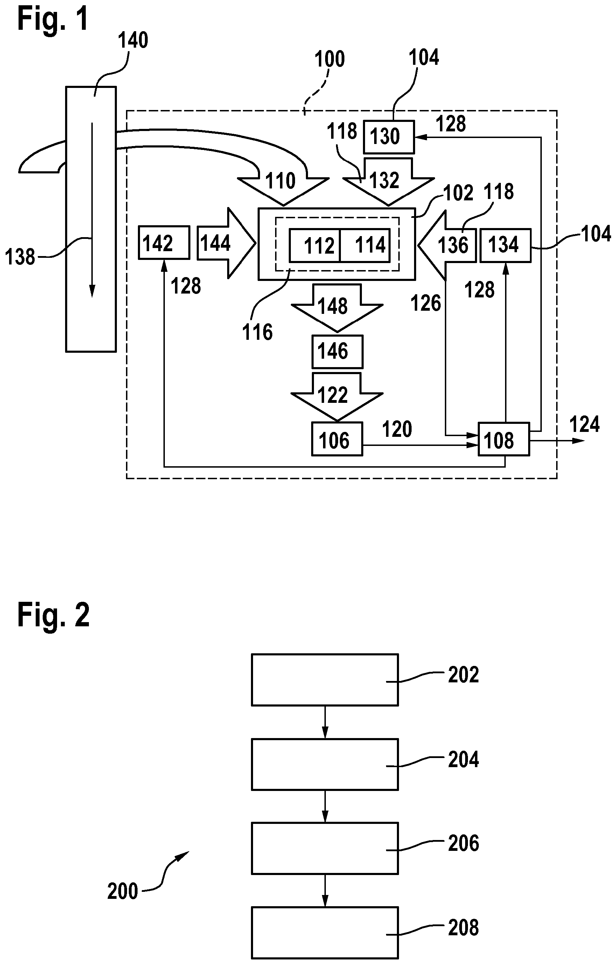

Fig. 1 zeigt ein Blockschaltbild eines Stromsensors 100 gemäß einem Ausführungsbeispiel der vorliegenden Erfindung. Der Stromsensor 100 weist ein Diamantmaterial 102, einen Emitter 104, einen Sensor 106 und eine Auswerteeinrichtung 108 auf. Der Magnetfeldsensor 100 ist dazu ausgebildet, ein Magnetfeld 110 zu messen. Um das Magnetfeld 110 zu messen, ist das Diamantmaterial 102 dem Magnetfeld 110 ausgesetzt. Das Diamantmaterial 102 weist zumindest eine Stickstoffeinlagerung 112 und eine zu der Stickstoffeinlagerung 112 benachbarte Fehlstelle 114 im Kristallgitter des Diamantmaterials 102 auf. Zusammen bilden die Stickstoffeinlagerung 112 und die Fehlstelle 114 ein Stickstoff-Fehlstellen-Zentrum 116 in dem Kristallgitter aus.

Der Emitter 104 ist dazu ausgebildet, elektromagnetische Wellen 118 bereitzustellen, um das Diamantmaterial 102 anzuregen. Der Sensor 106 ist dazu ausgebildet, eine Intensität 120 einer Fluoreszenz 122 des Diamantmaterials 102 zu erfassen.

Die Auswerteeinrichtung 108 ist dazu ausgebildet, eine Feldstärke 124 des Magnetfelds 110 unter Verwendung der Fluoreszenz-Intensität 120 und einer Frequenz 126 der elektromagnetischen Wellen 118 zu ermitteln.

Unter Verwendung der Feldstärke und dem Induktionsgesetz kann eine das Magnetfeld 110 hervorrufende elektrische Stromstärke bestimmt werden. Die elektrische Stromstärke kann in einer separaten oder einer in den Stromsensor 100 integrierten Bestimmungseinrichtung bestimmt werden.

In einem Ausführungsbeispiel ist die Auswerteeinrichtung 108 dazu ausgebildet, den Emitter 104 anzusteuern, um das Messen des Magnetfelds 110 auszuführen. Dazu stellt die Auswerteeinrichtung 108 Steuersignale 128 bereit.

Der Emitter 104 weist hier eine Lichtquelle 130 zum Bereitstellen von elektromagnetischen Wellen 118 im Lichtspektrum beziehungsweise Licht 132 auf. Weiterhin weist der Emitter 104 einen Mikrowellensender 134 zum Bereitstellen von elektromagnetischen Wellen 118 im Mikrowellenspektrum beziehungsweise Mikrowellen 136 auf. Die Auswerteeinrichtung 108 kann eine Intensität und/oder die Frequenz 126 der Lichtquelle 130 und/oder des Mikrowellensenders 134 ansteuern.

Das Magnetfeld 110 resultiert insbesondere durch einen Stromfluss 138 in einem elektrischen Leiter 140. Der Stromsensor 100 ist benachbart zu dem elektrischen Leiter 140 angeordnet, sodass das Magnetfeld 110 das Diamantmaterial 102 durchdringt, wenn der Strom 138 durch den Leiter 140 fließt.

In einem Ausführungsbeispiel weist der Stromsensor 100 eine Referenzmagnetfeldquelle 142 zum Bereitstellen eines Referenzmagnetfelds 144 auf. Durch das in seiner Ausrichtung und seiner Intensität bekannte Referenzmagnetfeld 144 wird das Diamantmaterial 102 auf eine bekannte Weise zum Fluoreszieren angeregt.

Da das Diamantmaterial 102 durch Licht 132 und Mikrowellen 136 angeregt wird, weist der Stromsensor 100 in einem Ausführungsbeispiel zwischen dem Diamantmaterial 102 und dem Sensor 106 einen optischen Filter 146 auf. Durch den Filter 146 werden unerwünschte Bestandteile des aus dem Diamant kommenden Lichtspektrums 148 (wie z. B. Teile aus der Lichtemission 132 des Emitters 130) aus dem Fluoreszenzsignal 148 ausgefiltert, um die Fluoreszenz 122 zu erhalten und diese störungsarm detektieren zu können.

Der hier vorgestellte Ansatz stellt einen Stromsensor 100 mit einer großen Dynamik in einem einzelnen Sensorelement 102 vor. Die vorgestellte Lösung basiert auf der Verwendung von NV-Zentren 116 in Diamant 102. NV Zentren 116 in Diamant reagieren extrem sensitiv auf externe Magnetfelder 110 und basieren auf dem Zeemann Effekt, also der Aufspaltung von quantisierten Zuständen im NV-Zentrum 116 des Diamantkristalls 102. Diese Aufspaltung reagiert linear auf Magnetfeldänderung über einen Magnet-Feldstärkenbereich von Nanotesla nT bis zu 1000 T.

Durch Anbringen eines NV-Sensors 100 an eine elektrische Leitung 140 lassen sich bei Stromfluss 138 die durch Induktion hervorgerufenen Magnetfeldänderungen 110 erfassen und über diese lässt sich dann die Stromstärke 138 im elektrischen Leiter 140 rückrechnen.

Bei dem hier vorgestellten Ansatz werden NV-Zentren 116 in Diamant 102 zur extrem genauen und berührungslosen Messung durch Strom 138 induzierter Magnetfelder 110 verwendet. Durch Rückrechnung kann unter Verwendung des Induktionsgesetzes auf die elektrische Stromstärke geschlossen werden.

Das durch Induktion hervorgerufene Magnetfeld 110 an einem stromdurchflossenen elektrischen Leiter 140 im Abstand r berechnet sich zu

$$B = \mu_0 \cdot \frac{I}{2\pi \cdot r}$$

Mit der magnetischen Feldkonstante $\mu_0$ und dem Strom I im Leiter 140.

Kernelemente dieses Sensorelements 100 sind die optische Anregung durch einen integrierten Lichtemitter 130 (LED oder VCSEL), ein mit NV-Zentren 116 versehener Diamantkristall 102, eine Mikrowellen-Streifenantenne 134 in unmittelbarer Nähe der Diamantmembran 102, eine optische Filterschicht 146 zur Filterung des aus dem Diamant kommenden Lichtspektrums 148 (Emission aus dem Emitter 132 plus Fluoreszenz 122) sowie eine integrierte Fotodiode 106 unterhalb der Diamantmembran 102 die die Fluoreszenz 122 der NV-Zentren 116 detektiert. Der Vorteil liegt als Allererstes darin, dass die dem Messprinzip zugrunde liegende Zeemann Aufspaltung der elektronischen Zustände im NV-Zentrum 116 in einem extrem hohen Feldstärkebereich linear auf externe Magnetfelder 110 reagiert, der Sensor 100 sich also prinzipiell für präzise Messung elektrischer Ströme 138 in einem extrem großen Messbereich von mA bis 1500 A eignet.

Fig. 2 zeigt ein Ablaufdiagramm eines Verfahrens 200 zum Messen eines Stroms gemäß einem Ausführungsbeispiel der vorliegenden Erfindung. Das Verfahren 200 kann unter Verendung eines Stromsensors, wie er beispielsweise in Fig. 1 dargestellt ist, ausgeführt werden. Der Stromsensor weist ein Diamantmaterial mit zumindest einer Stickstoffeinlagerung und einer zu der Stickstoffeinlagerung benachbarten Fehlstelle im Kristallgitter des Diamantmaterials auf. Das Diamantmaterial ist so angeordnet, dass es von einem durch einen elektrischen Stromfluss in einem Leiter hervorgerufenen Magnetfeld durchdrungen wird. Das Verfahren 200 weist einen Schritt 202 des Bereitstellens, einen Schritt 204 des Erfassens und einen Schritt 206 des Auswertens auf. Weiterhin weist das Verfahren 200 einen Schritt des Bestimmens 208 auf. Im Schritt 202 des Bereitstellens werden elektromagnetische Wellen zum Anregen des Diamantmaterials bereitgestellt. Im Schritt 204 des Erfassens wird eine Intensität einer Fluoreszenz des Diamantmaterials erfasst. Im Schritt 206 des Auswertens werden die Fluoreszenz-Intensität und eine Frequenz der elektromagnetischen Wellen ausgewertet, um eine magnetische Feldstärke des Magnetfelds zu ermitteln. Im Schritt des Bestimmens 208 wird der, das Magnetfeld hervorrufende Stromfluss, in dem Leiter unter Verwendung der Feldstärke und einer Verarbeitungsvorschrift bestimmt. Dabei bildet die Verarbeitungsvorschrift die geometrischen Verhältnisse zwischen dem Leiter und dem Stromsensor ab.

Im Schritt 202 des Bereitstellens kann in einem Ausführungsbeispiel ein Referenzmagnetfeld mit einer Referenzfeldstärke und einer Referenzfeldrichtung bereitgestellt werden, um das Diamantmaterial zu einer Referenzfluoreszenz anzuregen. Im Schritt 206 des Auswertens kann die Feldstärke ferner unter Verwendung der Referenzfeldstärke und der Referenzfeldrichtung ermittelt werden.

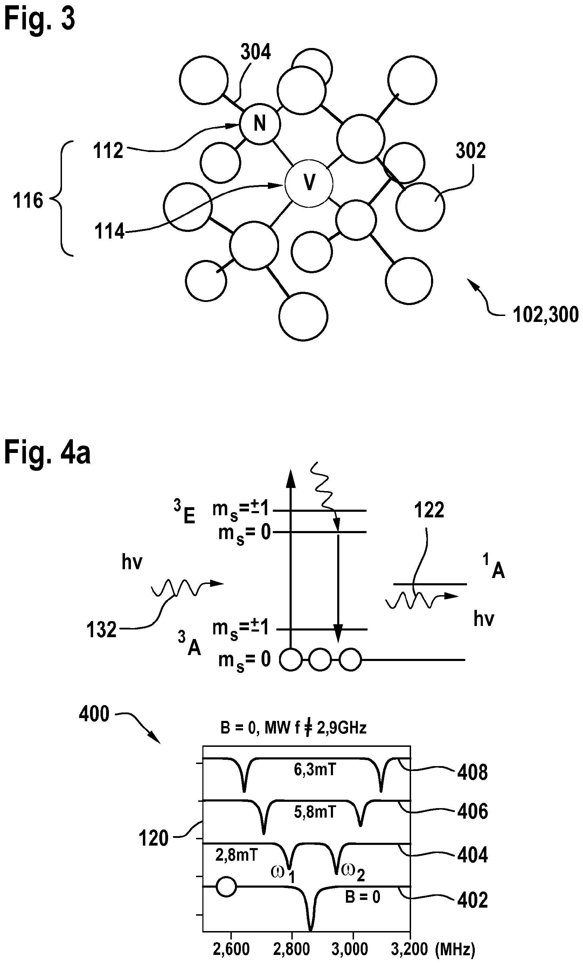

Fig. 3 zeigt eine Darstellung eines Diamantmaterials 102 mit einer Stickstoffeinlagerung 112 und einer Fehlstelle 114 gemäß einem Ausführungsbeispiel der vorliegenden Erfindung. Das Diamantmaterial 102 entspricht im Wesentlichen dem Diamantmaterial in Fig. 1.

Das Diamantmaterial 102 weist eine tetraedrische Kristallstruktur 300 beziehungsweise ein kubisches Kristallgitter 300 aus Kohlenstoffatomen 302 auf. Dabei weist jedes Kohlenstoffatom 302 vier Bindungen 304 auf, die in einem Winkel von näherungsweise 109,5 Grad zueinander ausgerichtet sind.

Die Stickstoffeinlagerung 112 besteht aus einem Stickstoffatom 112, das anstelle eines Kohlenstoffatoms 302 in das Kristallgitter 300 eingelagert ist. Dabei weist das Stickstoffatom 112 nur drei Bindungen 304 zu Kohlenstoffatomen 302 auf. An der Stelle, an der das vierte Kohlenstoffatom angeordnet wäre, ist unmittelbar benachbart zu dem Stickstoffatom 112 die Fehlstelle 114 im Kristallgitter 300 angeordnet. Die Fehlstelle 114 entspricht damit einem Loch in der Kristallstruktur 300. Die Drei zu der Fehlstelle 114 benachbarten Kohlenstoffatome 302 weisen je eine unbesetzte beziehungsweise freie Bindung auf.

Mit anderen Worten zeigt Fig. 3 ein Nitrogen-Vacancy-Zentrum 116 beziehungsweise Stickstoff-Fehlstellen-Zentrum 116 in Diamant 106. Ein Kohlenstoffatom 302 wurde durch ein Stickstoff-Atom 112 ersetzt, ein direkt benachbartes Kohlenstoff-Atom fehlt im Diamantgitter 300 als Vacancy 114.

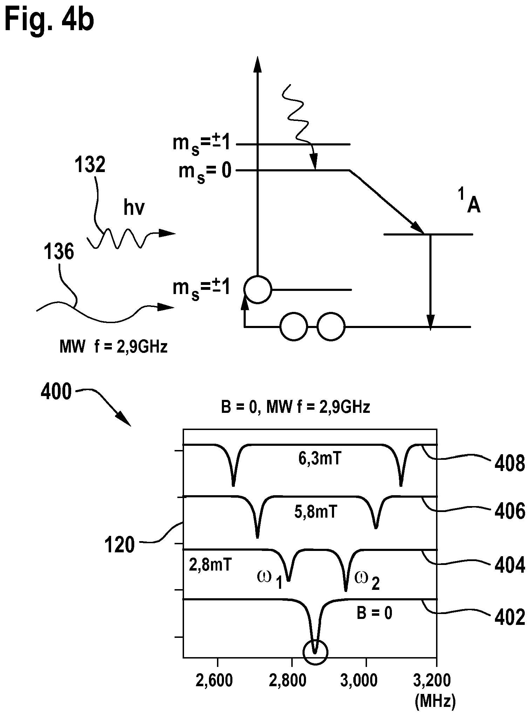

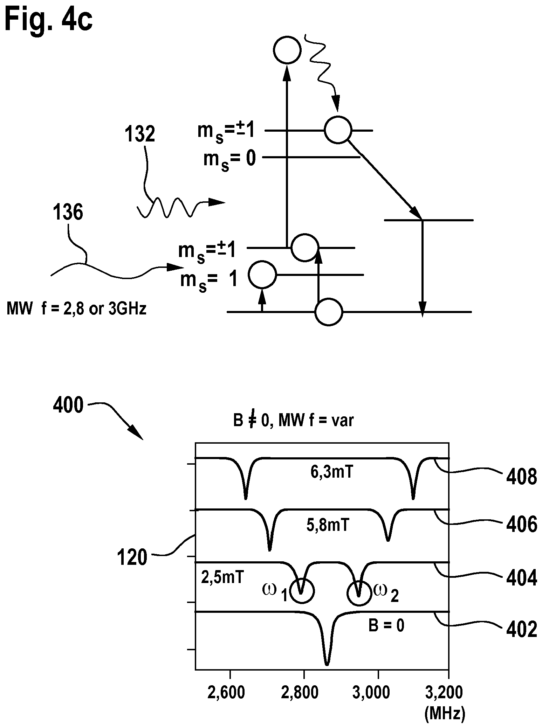

Die Figuren 4a, 4b und 4c zeigen eine Funktionsweise und Energieschemata der Strommessung über Fluoreszenzmessung bei zusätzlicher Mikrowellenanregung 136 gemäß einem Ausführungsbeispiel der vorliegenden Erfindung. Dabei wird das Diamantmaterial gleichzeitig mit Licht 132 und Mikrowellenenergie 136 angeregt. Die Funktionsweise ist anhand eines mehrdimensionalen Diagramms 400 dargestellt. In dem Diagramm ist auf der Abszisse ein Frequenzspektrum der Anregungsfrequenz der Mikrowellenanregung 136 aufgetragen. Dabei sind Frequenzen zwischen 2500 MHz und 3200 MHz angetragen. Auf der Ordinate ist die Intensität 120 der Fluoreszenz 122 aufgetragen. In dem Diagramm sind vier Verläufe 402, 404, 406, 408 der Intensität 120 übereinander dargestellt. Die Verläufe 402, 404, 406, 408 repräsentieren die Intensität 120 der Fluoreszenz 122 bei vier verschiedenen Feldstärken des Magnetfelds. Dabei repräsentiert ein erster Verlauf 402 die Fluoreszenz 120 über das Frequenzspektrum ohne Magnetfeld. Der erste Verlauf 402 weist ein lokales Minimum bei 2900 MHz Anregungsfrequenz auf. Bei Übereinstimmung der Mikrowellenfrequenz mit dem Energieabstand zwischen 3A und ms+-1 Niveau kommt es zum Einbruch der Fluoreszenz. Der zweite Verlauf 404 repräsentiert die Fluoreszenz 122 über das Frequenzspektrum mit einer magnetischen Feldstärke von 2,8 Millitesla (mT). Der zweite Verlauf 404 weist zwei lokale Minima bei $\omega 1$ und $\omega 2$ auf. Der dritte Verlauf 406 repräsentiert die Fluoreszenz 122 über das Frequenzspektrum mit einer magnetischen Feldstärke von 5,8 Millitesla (mT). Der dritte Verlauf 406 weist ebenfalls zwei lokale Minima auf. Zwischen den Minima des dritten Verlaufs 406 besteht ein größerer Frequenzabstand, als den Minima des zweiten Verlaufs 404. Der vierte Verlauf 408 repräsentiert die Fluoreszenz 122 über das Frequenzspektrum mit einer magnetischen Feldstärke von 8,3 Millitesla (mT). Auch der vierte Verlauf 408 weist zwei lokale Minima auf, die wiederum einen größeren Frequenzabstand aufweisen, als die Minima des dritten Verlaufs 406. Bei externem Magnetfeld spaltet das ms+-1 Niveau auf und es existieren zwei definierte Mikrowellenfrequenzen, bei denen die Fluoreszenz 122 abnimmt. Der Frequenzabstand ist dabei proportional zum Magnetfeld.

Zum Auswerten kann ein erstes lokales Intensitätsminimum bei einer ersten Frequenz der elektromagnetischen Wellen 136 ausgewertet werden. Weiterhin kann ein zweites lokales Intensitätsminimum bei einer zweiten Frequenz der elektromagnetischen Wellen 136 ausgewertet werden. Die Feldstärke kann unter Verwendung eines Frequenzabstands zwischen den Frequenzen ermittelt werden.

Die Intensitätsverläufe 402, 404, 406, 408 der Fluoreszenz 122 können erfasst werden, wenn die elektromagnetischen Wellen 136 als Frequenzverlauf bereitgestellt werden. Die Feldstärke kann durch den Zusammenhang zwischen dem Frequenzverlauf und den Intensitätsverläufen 402, 404, 406, 408 ermittelt werden.

NV-Zentren in Diamant besitzen das in Fig. 4 gezeigte Energiespektrum. Im Normalzustand ohne Mikrowelle 136 und ohne B-Feld zeigt das NV-Zentrum bei optischer Anregung 132 Fluoreszenz 122 im roten Wellenlängenbereich. Wird neben der optischen Anregung 132 noch Mikrowellenstrahlung 136 eingestrahlt, kommt es bei 2,88 GHz zu einem Einbruch der Fluoreszenz 122, da die Elektronen in diesem Fall vom m+-1 Niveau des 3A Zustandes auf das m+-1 Niveau des 3E Zustands gehoben werden und von dort nichtstrahlend rekombinieren. Bei externem Magnetfeld kommt es zur Aufspaltung des m+-1 Niveaus (Zeeman Splitting) und es zeigen sich bei Auftragung der Fluoreszenz 122 über die Frequenz der Mikrowellenanregung 136 zwei Dips im Fluoreszenzspektrum 404, 406, 408 deren Frequenzabstand proportional zur magnetischen Feldstärke ist. Die Magnetfeldsensitivität wird dabei durch die minimal auflösbare Frequenzverschiebung definiert und kann bis 100 pT/√Hz erreichen.

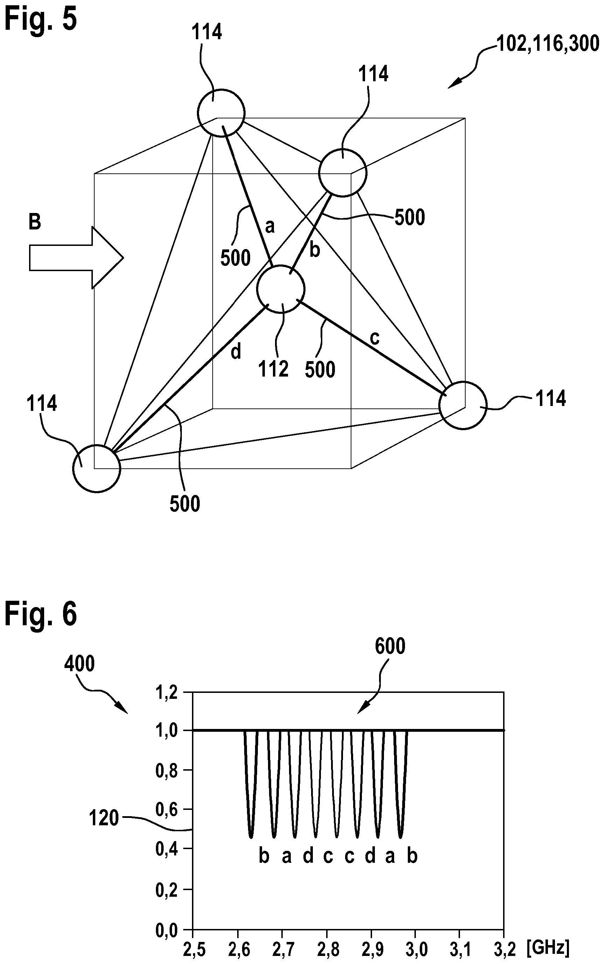

Fig. 5 zeigt eine Darstellung der möglichen Lagen einer Fehlstelle 114 in der Kristallstruktur 300 eines Diamantmaterials 102 gemäß einem Ausführungsbeispiel der vorliegenden Erfindung. Hier sind alle vier Möglichkeiten gleichzeitig dargestellt, wie die Fehlstelle 114 in Bezug zu dem Stickstoffatom 112 angeordnet sein kann. Davon ist bei einem Stickstoff-Fehlstellen-Zentrum 116 jeweils nur eine der vier Lagen möglich.

Mit anderen Worten zeigt Fig. 5 eine Kristall-Einheitszelle 300 von Diamant 102. Das NV-Zentrum 116 hat in dieser Einheitszelle 300 vier Möglichkeiten sich im Kristall anzuordnen. Da der Winkel zwischen Magnetfeldrichtung B und Kristallachse 500 für jede Kristallachse 500 unterschiedlich ist, kommt es zu unterschiedlich starken Frequenzaufspaltungen in den NV-Zentren 116, abhängig von der jeweiligen Kristallrichtung. Dies führt zu bis zu vier zusammengehörigen Paaren von Fluoreszenzdips im Fluoreszenzspektrum, wie sie in Fig. 6 dargestellt sind. Durch Auswertung der Frequenzabstände für jede Kristallrichtung lassen sich Magnetfeldrichtung und Stärke extrahieren.

Da das NV-Zentrum 116 im einkristallinen Diamant 102 vier Möglichkeiten besitzt, sich im Kristallgitter 300 anzuordnen kommt es bei Anwesenheit eines gerichteten Magnetfelds dazu, dass die im Kristall 300 vorhandenen NV-Zentren 116 je nach Lage im Kristall 300 unterschiedlich stark auf das äußere Magnetfeld reagieren. Dadurch können im Maximalfall vier einander zugehörige Paare von Fluoreszenz-Minima im Spektrum auftauchen, aus deren Form und Lage zueinander Betrag und Richtung des Magnetfelds eindeutig bestimmbar sind.

Fig. 6 zeigt lokale Intensitätsminima 600 in Abhängigkeit von der Lage einer Fehlstelle in der Kristallstruktur eines Diamantmaterials gemäß einem Ausführungsbeispiel der vorliegenden Erfindung. Die Intensitätsminima 600 sind wie in Fig. 4 in einem Diagramm 400 aufgetragen, das auf der Abszisse das Frequenzspektrum der Anregungsfrequenz und auf Ordinate die Intensität 120 der Fluoreszenz aufgetragen hat. Die Intensitätsminima 600 korrespondieren dabei mit den entsprechend gekennzeichneten Kristallachsen in Fig. 5.

Diese Eigenschaft kann im vorgeschlagenen Stromsensor dafür genutzt werden, die durch den elektrischen Strom induzierten Felder, die sich radial um den stromdurchflossenen Leiter ausbilden, deren Richtung also bekannt ist, von äußeren Störfeldern zu unterscheiden.

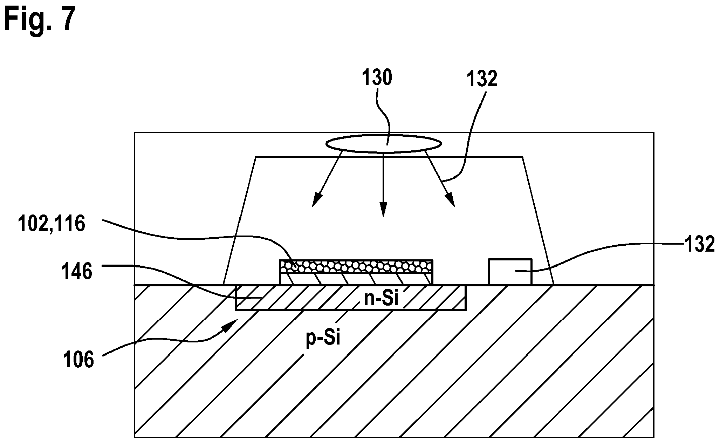

Fig. 7 zeigt eine Darstellung eines Stromsensors 100 gemäß einem Ausführungsbeispiel der vorliegenden Erfindung. Der Stromsensor entspricht im Wesentlichen dem Stromsensor in Fig. 1. In diesem Ausführungsbeispiel ist der Stromsensor 100 als monolithisch integrierter Magnetsensor 100 zur berührungslosen Strommessung ausgeführt. Die Lichtquelle 130 ist als LED oder VCSEL-Laserchip auf eine Si-Fotodiode 106 gebondet. Auf der Fotodiode 106 befindet sich ein optischer Filter 146 zur Filterung des Anregungslichts 132, darauf die mit NV-Zentren 116 versetzte Diamantschicht 102. Am Rand der Fotodiode 106 befindet sich eine RF-Streifenantenne 132 zur Einkopplung der Mikrowellenstrahlung.

Mit anderen Worten zeigt Fig. 7 einen Stromsensor 100 basierend auf NV-Zentren in Diamant 102.

Das präzise Messen des elektrischen Stroms ist für viele Anwendungen ein unverzichtbarer Bestandteil in elektrischen Systemen und Anlagen. Beispielhaft genannt seien hier das Erfassen der elektrischen Leistung in Stromzählern oder PV-Wechselrichtern zur genauen Berechnung der bezogenen oder ins Netz abgeführten Leistung, das Batteriemanagement in Elektrobzw. Hybridfahrzeugen oder solaren Batteriespeichern. Schließlich werden Strommessgeräte auch zur Detektion von Stromspitzen und entsprechenden elektrischen Absicherungssystemen verwendet.

Als bisherige Lösungen existieren Stromsensoren basierend auf dem Hall Effekt, FluxGate Sensoren oder einfache Glühfadensicherungen bzw. Sicherungsautomaten für Anwendungen zum Schutz vor Überspannung bzw. Strom. Hallsensoren oder Fluxgate Transducer können für die Belastungsanforderungen in e- bzw. Hybridfahrzeugen nicht genügend Dynamik besitzen, um Ströme vom mA bis zu 1500 Ampere zuverlässig messen zu können. Bei der bisher für diesen Fall verwendete Lösung durch Spannungsmessungen an Shunt-Widerständen im μOhm-Bereich liefern sehr geringe Ströme nur ein geringes Spannungssignal und sind damit in ihrer Messgenauigkeit begrenzt.

Der hier gezeigte Stromsensor 100 ist besonders geeignet für das Batteriemanagement im Automobil, da er den elektrischen Strom in einem Bereich von beispielsweise 1 mA bis 1500 A über sechs Größenordnungen zuverlässig erfassen kann.

Es ist eine mögliche Realisierung für ein monolithisch integriertes Sensorelement 100 basierend auf einem NV-versetzten Diamantkristall 102 dargestellt. Als Lichtquelle 130 kommt eine LED-Struktur oder ein VCSEL infrage. Zur monolithischen Integration ist es sinnvoll, den LED- oder VCSEL-Chip 130 beziehungsweise Wafer, der üblicherweise aus einem III/V Halbleitermaterial besteht über Chip to Wafer oder Chip to Chip Bondverfahren auf den Si-Wafer zu bonden, der die weiteren notwendigen Sensorelemente Diamantschicht 102, optisches Filter 146, Fotodiode 106 und RF Antenne 132 enthält. Zur Herstellung der letztgenannten Komponenten bietet sich an, als Erstes die Fotodiode 106 in den Si-Wafer zu strukturieren. Diese besteht aus p- und n-dotierten Gebieten, welche beispielsweise über Ionen-Implantation unter Verwendung von Schattenmasken strukturiert werden können. Auf die Fotodiode 106 wird dann eine optische Filterschicht 146 aufgebracht.

Mögliche Ausführungen wären z. B. dielektrische Filter, Microcavities mit semitransparenten Metallspiegeln, Farbstofffilter oder plasmonische Filter. Die NV-dotierte Diamantschicht 102 kann dann als separat hergestelltes Bauteil auf den Si-Wafer gebondet werden. Alternativ ist auch die integrierte CVD-Abscheidung einer Diamantschicht 102 möglich. Die Mikrowellenantenne 132 kann als metallische Streifenleitung auf dem Si-Wafer ausgeführt werden.

Um die Auswertung der strominduzierten Magnetfelder zu erleichtern, kann es von Vorteil sein, ein Referenzmagnetfeld in das Sensorelement 100 zu integrieren. Dies kann beispielsweise durch eine stromdurchflossene Spule, die in Dünnschicht-Metallisierungstechnik gefertigt sein kann oder durch permanentmagnetische Materialien erzeugt werden.

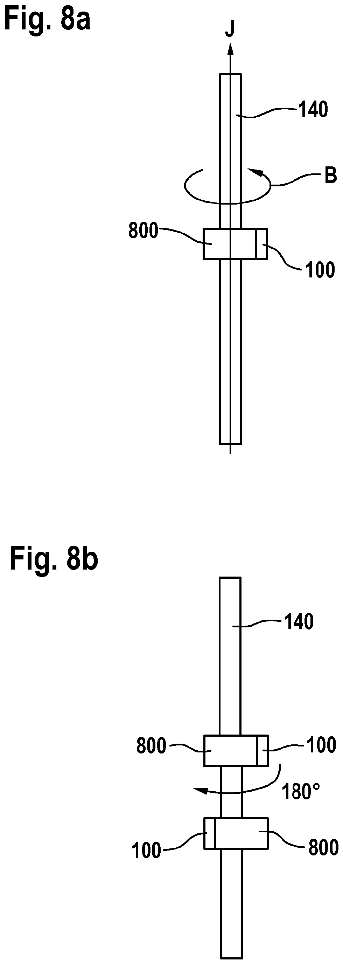

Die Figuren 8a und 8b zeigen Einbaubeispiele von Stromsensoren 100 gemäß Ausführungsbeispielen der vorliegenden Erfindung. In Fig. 8a ist ein einzelner Stromsensor 100 über einen mechanischen Träger 800 an einem elektrischen Leiter 140 befestigt. In Fig. 8b sind zwei gleichartige Stromsensoren 100 über mechanische Träger 800 an demselben elektrischen Leiter 140 befestigt. Die Stromsensoren sind zueinander um 180 Grad verdreht angeordnet.

Mit anderen Worten zeigen die Figuren 8a und 8b das Anbringen von NV-Sensoren 100 an einem elektrischen Leiter 140. Der Sensorchip 100 basierend auf NV-Zentren lässt sich beispielsweise auf einen mechanischen Träger 800 kleben, der an den Leiter 140 festgemacht werden kann. Der mechanische Träger 800 ist so ausgeführt, dass er immer den gleichen Abstand zwischen Leiter 140 und Sensorelement 100 gewährleistet, da das zu messende resultierende Magnetfeld sehr stark vom Abstand r zum Leiter 140 abhängt. Um Streufeldeinflüsse zu minimieren, kann es vorteilhaft sein, zwei Sensorelemente 100 mit einem Winkelversatz von beispielsweise 90 Grad einzusetzen.

Unter Verwendung der Feldstärke und des Induktionsgesetztes kann die das Magnetfeld verursachende Stromstärke ermittelt werden.

Um die Störfeldeinflüsse auf das Messsignal weiter zu minimieren, besteht die Möglichkeit, ein zweites Sensorelement 100 in unmittelbarer Nähe des ersten Sensorelements 100 an die elektrische Leitung 140 anzubringen, welches jedoch radial um 180 Grad versetzt am elektrischen Leiter 140 befindet. So lassen sich auch solche Störfelder herausfiltern, die zufällig ebenfalls in radialer Richtung an der Einbauposition des ersten Sensorelements 100 verlaufen. Durch Mittelung der Absolutmagnetfelder beider Sensorelemente 100 lässt sich das Störfeld herausrechnen.

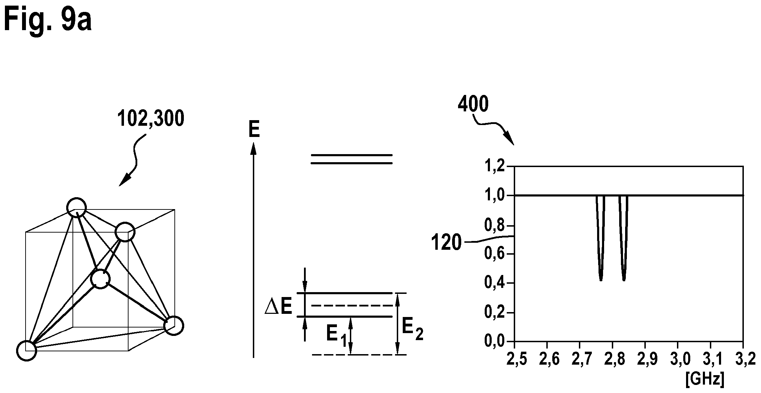

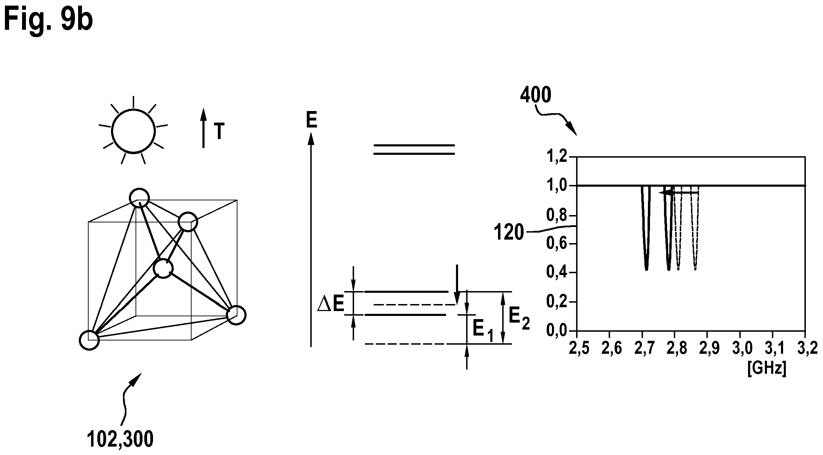

Die Figuren 9a und 9b zeigen eine Funktionsweise und Energieschemata der Temperaturmessung über Fluoreszenzmessung bei zusätzlicher Mikrowellenanregung gemäß einem Ausführungsbeispiel der vorliegenden Erfindung. In Fig. 9a ist das Kristallgitter 300 des Diamantmaterials 102 bei geringer Temperatur beziehungsweise Raumtemperatur dargestellt. In Fig. 9b ist das Kristallgitter 300 bei erhöhter Temperatur dargestellt. Durch den Temperaturunterschied ergibt sich ein Größenunterschied des Diamantmaterials zwischen den beiden Temperaturen.

Neben dem Kristallgitter 300 ist jeweils das Energieschema und das Diagramm 400, wie in den Figuren 4 und 6 zeigt das Diagramm 400 die Intensität 120 der Fluoreszenz über dem Frequenzspektrum der Anregung. Wenn sich das Kristallgitter 300 ausdehnt, verschieben sich die lokalen Minima hin zu niedrigeren Frequenzen. Dadurch kann die Temperatur des Diamantmaterials 102 aus den Frequenzen der Minima berechnet werden.

Mit anderen Worten zeigt Fig. 9 eine Temperaturmessung mit NV-Zentren. Bei Temperaturänderung, hier einer Temperaturerhöhung zwischen den Figuren 9a und 9b, dehnt sich der Kristall 300 isotrop aus und die im Fluoreszenzspektrum auftretenden Fluoreszenzdips verschieben sich für alle Kristallachsen gleichmäßig zu kleineren Frequenzen. Zur Vereinfachung ist das hier nur für eine Kristallachse gezeigt. Die Aufspaltung durch ein externes Magnetfeld bleibt dabei erhalten und wird durch die T-Änderung nicht beeinflusst.

Durch zusätzliche Auswertealgorithmen kann die Temperatur am Sensorelement 102 erfasst werden. Bei einer Temperaturerhöhung kommt es zu einer volumetrischen Ausdehnung des Diamantkristalls 102. Dadurch sinkt der energetische Abstand von Grundniveau und dem Energieschwerpunkt von m-1 und m+1 Niveau des NV-Zentrums, was mit einer gleichmäßigen Frequenzverschiebung zusammengehöriger Fluoreszenzminima einhergeht. Diese isotrope Verschiebung beeinflusst nicht den Betrag der Zeemann Aufspaltung, was die Bestimmung der Temperatur unabhängig vom Magnetfeld ermöglicht. Die zusätzliche Temperaturmessung an der Einbauposition des Stromsensors kann vielfältig genutzt werden.

Beispielsweise kann die Temperaturmessung als Plausibilisierung des Strommesswerts durch Messung von induziertem Magnetfeld und Messung der Erwärmung des elektrischen Leiters hervorgerufen durch ohmsche Verluste verwendet werden, die ebenfalls proportional zur Stromstärke sind.

Ebenso kann die Temperaturmessung zur Überwachung der Temperatur der Batterie verwendet werden, sofern der Sensor direkt am Batteriekontakt der Batterie angebracht wird.

Schließlich kann die Temperaturmessung für eine Warnung vor Kabelbrand verwendet werden.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden. Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist. In jedem Fall ist die Erfindung so, wie sie durch die Ansprüche definiert ist.

**Patentansprüche**

1. Verfahren (200) zum Messen eines ein Magnetfeld bewirkenden elektrischen Stroms (138) unter Verwendung eines dem Magnetfeld (110) aussetzbaren Diamantmaterials (102), wobei das Diamantmaterial (102) mehrere NV-Zentren (116) umfasst, wobei ein NV-Zentrum (116) eine Stickstoffeinlagerung (112) und eine zu der Stickstoffeinlagerung (112) benachbarte Fehlstelle (114) in einem Kristallgitter (300) des Diamantmaterials (102) aufweist und jeweils eine von vier möglichen Lagen im Kristallgitter (300) des Diamantmaterials (102) aufweist, wobei das Verfahren (200) die folgenden Schritte aufweist:

Bereitstellen (202) von Licht als erste elektromagnetische Wellen (132) in einem ersten Frequenzspektrum und von Mikrowellen als zweite elektromagnetische Wellen (136) in einem zweiten Frequenzspektrum, um das Diamantmaterial (102) zu einer Fluoreszenz (122) anzuregen;
Erfassen (204) einer Fluoreszenz-Intensität (120) der Fluoreszenz (122), wobei das Diamantmaterial (102) mit einer veränderlichen Anregungsfrequenz durch die zweiten elektromagnetischen Wellen (136) angeregt wird und dadurch Intensitätsminima (600) der Fluoreszenz erfasst werden, welche von der Lage der NV-Zentren (116) im Kristallgitter (300) des Diamantmaterials abhängen;
Auswerten (206) der Fluoreszenz-Intensität (120) und einer Frequenz (126) der zweiten elektromagnetischen Wellen (136), um eine die Fluoreszenz beeinflussende magnetische Feldstärke (124) des Magnetfelds (110) zu ermitteln, wobei aus Form und Lage der Intensitätsminima (600) ein Betrag und eine Richtung des Magnetfelds (110) bestimmt werden; und
Bestimmen (208) einer Stromstärke des Stroms (138) unter Verwendung der magnetischen Feldstärke (124).

2. Verfahren (200) gemäß Anspruch 1, bei dem im Schritt (206) des Auswertens für bis zu vier zusammengehörige Paare von Intensitätsminima (600), jeweils ein erstes lokales Intensitätsminimum der Fluoreszenz (122) bei einer ersten Frequenz der zweiten elektromagnetischen Wellen (136) und ein zweites lokales Intensitätsminimum der Fluoreszenz (122) bei einer zweiten Frequenz der zweiten elektromagnetischen Wellen (136) ausgewertet wird, wobei die Intensitätsminima (600) mit den vier möglichen Lagen der NV-Zentren (116) im Kristallgitter (300) des Diamantmaterials (102) korrespondieren, und wobei durch eine Auswertung der Frequenzabstände, wobei ein Frequenzabstand jeweils den Abstand zwischen der ersten Frequenz und der zweiten Frequenz bezeichnet, für jede Kristallrichtung Magnetfeldrichtung und Magnetfeldstärke des Magnetfeldes (110) bestimmt werden.

3. Verfahren (200) gemäß einem der vorangegangenen Ansprüche, bei dem im Schritt (202) des Bereitstellens die zweiten elektromagnetischen Wellen (136) als Frequenzverlauf eingestrahlt werden und im Schritt (204) des Erfassens ein Intensitätsverlauf (402, 404, 406, 408) der Fluoreszenz (122) erfasst wird, wobei im Schritt (206) des Auswertens die Feldstärke (124) unter Verwendung eines Zusammenhangs zwischen dem Frequenzverlauf und dem Intensitätsverlauf (402, 404, 406, 408) ermittelt wird.

4. Verfahren (200) gemäß einem der vorangegangenen Ansprüche, bei dem im Schritt (202) des Bereitstellens ferner ein Referenzmagnetfeld (144) mit einer Referenzfeldstärke und einer Referenzfeldrichtung bereitgestellt wird, um das Diamantmaterial (122) zu einer Referenzfluoreszenz anzuregen, wobei im Schritt (206) des Auswertens die Feldstärke (124) ferner unter Verwendung der Referenzfeldstärke und der Referenzfeldrichtung ermittelt wird.

5. Verfahren (200) gemäß einem der vorangegangenen Ansprüche, mit einem Schritt des Filterns einer Emission (148) des Diamantmaterials (102), um die Fluoreszenz (122) zu erhalten.

6. Verfahren (200) gemäß einem der vorangegangenen Ansprüche, bei dem im Schritt (206) des Auswertens ferner eine Temperatur des Diamantmaterials (102) unter Verwendung der Frequenz (126) ermittelt wird.

7. Stromsensor (100) zum Messen eines ein Magnetfeld bewirkenden elektrischen Stroms (138), wobei der Stromsensor (100) die folgenden Merkmale aufweist:

ein dem Magnetfeld (110) aussetzbares Diamantmaterial (202), das mehrere NV-Zentren (116) umfasst, wobei ein NV-Zentrum (116) eine Stickstoffeinlagerung (112) und eine zu der Stickstoffeinlagerung (112) benachbarte Fehlstelle (114) im Kristallgitter (300) des Diamantmaterials (102) aufweist und jeweils eine von vier möglichen Lagen im Kristallgitter (300) des Diamantmaterials (102) aufweist;
einen Emitter (104) zum Bereitstellen von ersten elektromagnetischen Wellen (132) in einem ersten Frequenzspektrum und von zweiten elektromagnetischen Wellen (136) in einem zweiten Frequenzspektrum, um das Diamantmaterial (102) zu einer Fluoreszenz (122) anzuregen;
einen Sensor (106) zum Erfassen einer Fluoreszenz-Intensität (120) der Fluoreszenz (122), wobei das Diamantmaterial (102) mit einer veränderlichen Anregungsfrequenz durch die zweiten elektromagnetischen Wellen (136) anregbar und dadurch Intensitätsminima (600) der Fluoreszenz erfassbar sind, welche von der Lage der NV-Zentren (116) im Kristallgitter (300) des Diamantmaterials abhängen;
eine Auswerteeinrichtung (108) zum Ermitteln einer Feldstärke (124) des Magnetfelds (110) unter Verwendung der Fluoreszenz-Intensität

(120) und einer Frequenz (126) der zweiten elektromagnetischen Wellen (136), wobei aus Form und Lage der Intensitätsminima (600) ein Betrag und eine Richtung des Magnetfelds (110) bestimmt werden; und
eine Bestimmungseinrichtung zum Bestimmen einer Stromstärke des Stroms (138) unter Verwendung der magnetischen Feldstärke (124).

8. Computerprogramm, das dazu eingerichtet ist, alle Schritte eines Verfahrens gemäß einem der Ansprüche 1 bis 6 in einem Stromsensor nach Anspruch 7 durchzuführen, umzusetzen und/oder anzusteuern.

9. Maschinenlesbares Speichermedium mit einem darauf gespeicherten Computerprogramm nach Anspruch 8.

**Claims**

1. Method (200) for measuring an electric current (138) causing a magnetic field, using a diamond material (102) to be exposed to the magnetic field (110), wherein the diamond material (102) comprises a plurality of NV centres (116), wherein an NV centre (116) has a nitrogen incorporation (112) and a defect (114), adjacent to the nitrogen incorporation (112), in a crystal lattice (300) of the diamond material (102) and has in each case one of four possible locations in the crystal lattice (300) of the diamond material (102), wherein the method (200) includes the following steps:

providing (202) light as first electromagnetic waves (132) in a first frequency spectrum and microwaves as second electromagnetic waves (136) in a second frequency spectrum in order to excite the diamond material (102) to fluorescence (122);
capturing (204) a fluorescence intensity (120) of the fluorescence (122), wherein the diamond material (102) is excited with a variable excitation frequency by way of the second electromagnetic waves (136) and consequently intensity minima (600) of the fluorescence, which depend on the location of the NV centres (116) in the crystal lattice (300) of the diamond material, are captured;
evaluating (206) the fluorescence intensity (120) and a frequency (126) of the second electromagnetic waves (136) in order to ascertain a magnetic field strength (124) of the magnetic field (110) influencing the fluorescence, wherein a magnitude and a direction of the magnetic field (110) are determined from the shape and location of the intensity minima (600); and
determining (208) a current strength of the current (138) using the magnetic field strength (124).

2. Method (200) according to Claim 1, in which, in the evaluation step (206), in each case a first local intensity minimum of the fluorescence (122) at a first frequency of the second electromagnetic waves (136) and a second local intensity minimum of the fluorescence (122) at a second frequency of the second electromagnetic waves (136) is evaluated for up to four associated pairs of intensity minima (600), wherein the intensity minima (600) correspond to the four possible locations of the NV centres (116) in the crystal lattice (300) of the diamond material (102), and wherein the magnetic field direction and magnetic field strength of the magnetic field (110) are determined for each crystal direction by evaluating the frequency distances, wherein a frequency distance in each case denotes the distance between the first frequency and the second frequency.

3. Method (200) according to either of the preceding claims, in which, in the providing step (202), the second electromagnetic waves (136) are radiated in as a frequency profile and, in the capturing step (204), an intensity profile (402, 404, 406, 408) of the fluorescence (122) is captured, wherein, in the evaluation step (206), the field strength (124) is ascertained using a relationship between the frequency profile and the intensity profile (402, 404, 406, 408).

4. Method (200) according to one of the preceding claims, in which, in the providing step (202), furthermore a reference magnetic field (144) with a reference field strength and a reference field direction is provided in order to excite the diamond material (122) to a reference fluorescence, wherein, in the evaluation step (206), the field strength (124) is furthermore ascertained using the reference field strength and the reference field direction.

5. Method (200) according to one of the preceding claims, having a step of filtering an emission (148) of the diamond material (102) in order to obtain the fluorescence (122).

6. Method (200) according to one of the preceding claims, in which, in the evaluation step (206), furthermore a temperature of the diamond material (102) is ascertained using the frequency (126).

7. Current sensor (100) for measuring an electric current (138) causing a magnetic field, wherein the current sensor (100) has the following features:

a diamond material (202), which is to be exposed to the magnetic field (110) and comprises a plurality of NV centres (116), wherein an NV centre (116) has a nitrogen incorporation (112) and a defect (114), adjacent to the nitrogen incorporation (112), in the crystal lattice (300) of the diamond material (102) and has in each case one of four possible locations in the crystal lattice (300) of the diamond material (102);

an emitter (104) for providing first electromagnetic waves (132) in a first frequency spectrum and second electromagnetic waves (136) in a second frequency spectrum in order to excite the diamond material (102) to fluorescence (122);

a sensor (106) for capturing a fluorescence intensity (120) of the fluorescence (122), wherein the diamond material (102) is excitable with a variable excitation frequency by way of the second electromagnetic waves (136) and consequently intensity minima (600) of the fluorescence, which depend on the location of the NV centres (116) in the crystal lattice (300) of the diamond material, are capturable;

an evaluation device (108) for ascertaining a field strength (124) of the magnetic field (110) using the fluorescence intensity (120) and a frequency (126) of the second electromagnetic waves (136), wherein a magnitude and a direction of the magnetic field (110) are determined from the shape and location of the intensity minima (600); and

a determination device for determining a current strength of the current (138) using the magnetic field strength (124) .

8. Computer program configured to perform, realize and/or control all the steps of a method according to one of Claims 1 to 6 in a current sensor according to Claim 7.

9. Machine-readable storage medium having a computer program according to Claim 8 stored thereon.

**Revendications**

1. Procédé (200) permettant de mesurer un courant électrique (138) créant un champ magnétique en utilisant un matériau diamanté (102) pouvant être exposé au champ magnétique (110), le matériau diamanté (102) comprenant plusieurs centres NV (116), un centre NV (116) présentant une inclusion d'azote (112) et une lacune (114) adjacente à l'inclusion d'azote (112) dans un réseau cristallin (300) du matériau diamanté (102) et présentant respectivement une de quatre positions possibles dans le réseau cristallin (300) du matériau diamanté (102), le procédé (200) présentant les étapes suivantes consistant à :

fournir (202) de la lumière sous forme de premières ondes électromagnétiques (132) dans un premier spectre de fréquences et des microondes sous forme de deuxièmes ondes électromagnétiques (136) dans un deuxième spectre de fréquences afin d'exciter le matériau diamanté (102) en fluorescence (122) ;

détecter (204) une intensité de fluorescence (120) de la fluorescence (122), le matériau diamanté (102) étant excité à une fréquence d'excitation variable par les deuxièmes ondes électromagnétiques (136), et de ce fait, des minima d'intensité (600) de la fluorescence étant détectés qui dépendant de la position des centres NV (116) dans le réseau cristallin (300) du matériau diamanté ;

évaluer (206) l'intensité de fluorescence (120) et une fréquence (126) des deuxièmes ondes électromagnétiques (136) pour déterminer une force de champ magnétique (124) du champ magnétique (110), influençant la fluorescence, une quantité et une direction du champ magnétique (110) étant déterminées à partir de la forme et de la position des minima d'intensité (600) ; et

déterminer (208) une force de courant du courant (138) en utilisant la force de champ magnétique (124).

2. Procédé (200) selon la revendication 1, dans lequel, à l'étape (206) d'évaluation, pour jusqu'à quatre paires associées de minima d'intensité (600), respectivement un premier minimum d'intensité local de la fluorescence (122) est évalué à une première fréquence des deuxièmes ondes électromagnétiques (136) et un deuxième minimum d'intensité local de la fluorescence (122) est évalué à une deuxième fréquence des deuxièmes ondes électromagnétiques (136), les minima d'intensité (600) correspondant aux quatre positions possibles des centres NV (116) dans le réseau cristallin (300) du matériau diamanté (102), et dans lequel une évaluation des distances de fréquence, une distance de fréquence désignant respectivement la distance entre la première fréquence et la deuxième fréquence, permet de déterminer pour chaque direction du cristal la direction de champ magnétique et la force de champ magnétique du champ magnétique (110).

3. Procédé (200) selon l'une quelconque des revendications précédentes, dans lequel, à l'étape (202) de fourniture, les deuxièmes ondes électromagnétiques (136) sont injectées comme une courbe de fréquence, et à l'étape (204) de détection, une courbe d'intensité (402, 404, 406, 408) de la fluorescence (122) est détectée, dans lequel, à l'étape (206) d'évaluation, la force de champ (124) est déterminée en utilisant une relation entre la courbe de fréquence et la courbe d'intensité (402, 404, 406, 408) .

4. Procédé (200) selon l'une quelconque des revendications précédentes, dans lequel, à l'étape (202) de fourniture, en outre un champ magnétique de référence (144) ayant une force de champ de référence et une direction de champ de référence est fourni pour exciter le matériau diamanté (122) en fluorescence de référence, dans lequel, à l'étape (206) d'évaluation, la force de champ (124) est en outre déterminée en utilisant la force de champ de référence et la direction de champ de référence.

5. Procédé (200) selon l'une quelconque des revendications précédentes, comprenant une étape de filtrage d'une émission (148) du matériau diamanté (102) pour maintenir la fluorescence (122).

6. Procédé (200) selon l'une quelconque des revendications précédentes, dans lequel, à l'étape (206) d'évaluation, en outre une température du matériau diamanté (102) est déterminée en utilisant la fréquence (126) .

7. Capteur de courant (100) permettant de mesurer un courant électrique (138) créant un champ magnétique, le capteur de courant (100) présentant les particularités suivantes :

un matériau diamanté (202) pouvant être exposé au champ magnétique (110) et qui comprend plusieurs centres NV (116), un centre NV (116) présentant une inclusion d'azote (112) et une lacune (114) adjacente à l'inclusion d'azote (112) dans le réseau cristallin (300) du matériau diamanté (102) et présentant respectivement une de quatre positions possibles dans le réseau cristallin (300) du matériau diamanté (102) ;

un émetteur (104) pour fournir des premières ondes électromagnétiques (132) dans un premier spectre de fréquences et des deuxièmes ondes électromagnétiques (136) dans un deuxième spectre de fréquences pour exciter le matériau diamanté (102) en fluorescence (122) ;

un capteur (106) pour détecter une intensité de fluorescence (120) de la fluorescence (122), le matériau diamanté (102) pouvant être excité à une fréquence d'excitation variable par les deuxièmes ondes électromagnétiques (136), et de ce fait, des minima d'intensité (600) de la fluorescence pouvant être détectés qui dépendent de la position des centres NV (116) dans le réseau cristallin (300) du matériau diamanté ;

un dispositif d'évaluation (108) pour déterminer une force de champ (124) du champ magnétique (110) en utilisant l'intensité de fluorescence (120) et une fréquence (126) des deuxièmes ondes électromagnétiques (136), une quantité et une direction du champ magnétique (110) étant déterminées à partir de la forme et de la position des minima d'intensité (600) ; et

un dispositif de détermination pour déterminer une force de courant du courant (138) en utilisant la force de champ magnétique (124).

8. Programme informatique qui est aménagé pour exécuter, mettre en œuvre et/ou piloter toutes les étapes d'un procédé selon l'une quelconque des revendications 1 à 6 dans un capteur de courant selon la revendication 7.

9. Support de stockage lisible par machine avec un programme informatique stocké sur celui-ci selon la revendication 8.

# Fig. 1

# Fig. 2

# Fig. 3

# Fig. 4a

# Fig. 4b

# Fig. 4c

132

136

$m_s = \pm 1$

$m_s = 0$

$m_s = \pm 1$

$m_s = 1$

MW  f = 2,8 or 3GHz

400

B ≠ 0, MW f = var

6,3mT — 408

5,8mT — 406

120

2,5mT — 404

$\omega_1$  $\omega_2$

B = 0 — 402

2,600    2,800    3,000    3,200
(MHz)

# Fig. 5

# Fig. 6

EP 3 292 416 B1

**Fig. 7**

# Fig. 8a

# Fig. 8b

EP 3 292 416 B1

# Fig. 9a

102,300

$E$

$\Delta E$

$E_1$   $E_2$

400

120

1,2
1,0
0,8
0,6
0,4
0,2
0,0

2,5  2,6  2,7  2,8  2,9  3,0  3,1  3,2

[GHz]

Fig. 9b

**EP 3 292 416 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2013188732 A1
- US 20110120890 A1